Europäisches Patentamt

European Patent Office

Office européen des brevets

(19)

(11) Numéro de publication: **0 206 918 B1**

# (12) FASCICULE DE BREVET EUROPEEN

(45) Date de publication de fascicule du brevet:
**10.04.91**

(51) Int. Cl.5: **H01L 31/10, H01L 29/205**

(21) Numéro de dépôt: **86401300.8**

(22) Date de dépôt: **16.06.86**

(54) **Procédé de réalisation d'un dispositif photodétecteur semiconducteur à avalanche, et dispositif ainsi réalisé.**

(30) Priorité: **18.06.85 FR 8509243**

(43) Date de publication de la demande:
**30.12.86 Bulletin 86/52**

(45) Mention de la délivrance du brevet:
**10.04.91 Bulletin 91/15**

(84) Etats contractants désignés:
**DE GB**

(56) Documents cités:
**EP-A- 0 131 437**
**GB-A- 2 107 927**

**APPLIED PHYSICS LETTERS, vol. 45, no. 11, décembre 1984, pages 1193-1195, American Istitute of Physics, New York, US; F. CAPAS-SO et al.: "Pseudo-quaternary GaInAsP se-miconductors: A new Ga0.47In0.53As/InP graded gap superlattice and its applications to avalanche photodiodes"**

**LASER FOCUS, vol. 20, no. 7, juillet 1984, pages 84-101, Newton, Massachusetts, US; F. CAPASSO: "Multilayer avalanche photodio-des and solid-state photomultipliers"**

(73) Titulaire: **THOMSON-CSF**
**51, Esplanade du Général de Gaulle**
**F-92800 Puteaux(FR)**

(72) Inventeur: **Weil, Thierry**
**THOMSON CSF SCPI 19, avenue de Messine**
**F-75008 Paris(FR)**
Inventeur: **Vinter, Borge**
**THOMSON CSF SCPI 19, avenue de Messine**
**F-75008 Paris(FR)**

(74) Mandataire: **Lepercque, Jean et al**
**THOMSON-CSF SCPI**
**F-92045 PARIS LA DEFENSE CEDEX 67(FR)**

Rank Xerox (UK) Business Services

## Description

La présente invention concerne un procédé de réalisation d'un dispositif photodétecteur semiconducteur à avalanche du type à zone d'absorption et de multiplication séparées.

Pour augmenter les performances des photodétecteurs à avalanche (réduction du bruit), on utilise classiquement des hétérostructures.

L'absorption a lieu principalement dans le matériau à petite largeur de bande interdite et la multiplication dans le milieu à grande largeur de bande interdite. Dans un tel dispositif, des porteurs, par exemple des trous, peuvent être stockés temporairement par la barrière de potentiel de l'hétérojonction, conduisant à des temps de réponse trop élevés, typiquement quelques dizaines de nanosecondes pour un dispositif à jonction de structure Indium-Gallium-Arsenic/Indium-Phosphore (InGaAs/InP).

Selon une seconde approche de l'Art Connu, on peut résoudre ce problème en remplaçant l'hétérojonction par une région de largeur de bande interdite variable. Facile à réaliser dans le cas du système de jonction du type Gallium-Arsenic/Aluminium-Gallium-Arsenic (GaAs/AlGaAs), une telle variation est techniquement très difficile à réaliser sans introduire de désaccord de maille dans un système tel que les jonctions du type Indium-Gallium-Arsenic/Indium-Phosphore (InGaAs/InP). Cela provient, entre autre, de difficultés à maîtriser la composition exacte du composé quaternaire intermédiaire.

Selon une troisième approche de l'Art Connu, on peut également réduire le temps de réponse en remplaçant l'hétérojonction abrupte par une succession de couches minces des deux composés extrêmes, Indium-Phosphore et Indium-Gallium-Arsenic par exemple.

Une telle méthode a été décrite dans l'article de CAPASSO et al. : "Pseudo-quaternary GaInAsP semiconductors : A new $Ga_{0.47}$ $In_{0.53}$As/InP graded gap superlattice and its applications to avalanche photodiodes" paru dans la revue US : "Applied Physics Letters", vol. 45, N°11, 1 décembre 1984, pages 1193-1195.

Le but recherché est de fabriquer un "pseudo-alliage quaternaire" qui ait les mêmes caractéristiques locales moyennes de potentiel qu'un alliage de composition variable selon la seconde approche de l'Art Connu. Il est imposé au système une longueur de maille constante. Une maille est constituée par un puits et la barrière de potentiel qui le suit. Cela conduit à considérer des systèmes avec de très nombreux puits, typiquement une vingtaine.

Cette méthode ne permet donc pas de réaliser des photodétecteurs à avalanche optimisés. Le nombre élevé de "tranches" de semiconducteurs à réaliser conduit à des difficultés de fabrication.

L'invention se fixe pour but un procédé de réalisation de dispositifs photodétecteurs semiconducteurs à avalanche palliant les inconvénients de l'Art Connu.

La structure d'un dispositif selon l'invention comporte, comme dans le cas de la troisième approche de l'Art Connu, un réseau de couches de matériaux semiconducteurs alternés.

Cependant, l'approche de départ est différente, ce qui permet, à caractéristique de vitesse de fonctionnement comparable, de réduire de façon notable le nombre de couches alternées, c'est-à-dire d'optimiser la structure de ces couches et par là, la structure du détecteur.

Outre l'économie sur la fabrication obtenue, en réduisant le nombre d'interfaces, on améliore la qualité du dispositif puisque chaque interface engendre des défauts.

L'invention a donc pour objet un procédé de réalisation d'un photodétecteur à avalanche du type comprenant au moins une région d'absorption de photons, dans laquelle sont photoinduits des porteurs, en un premier matériau semiconducteur à faible largeur de bande interdite, une région de multiplication de porteurs, en un second matériau semiconducteur à grande largeur de bande interdite, et une troisième région intermédiaire, constituée par un réseau de tranches de couches alternées des premier et second matériaux formant un système de puits quantiques couplés séparés par des barrières de potentiel; caractérisé en ce que, le photodétecteur étant spécifié pour des conditions de fonctionnement comprenant une discontinuité de bande et un champ électrique local déterminés ainsi qu'un temps de réponse maximum, il comprend une phase de détermination de ladite région intermédiaire comportant un nombre minimum de tranches de couches alternées d'épaisseurs variables assurant un temps de réponse inférieur ou égal audit temps de réponse maximum et en ce que cette phase comprend :
- une étape de détermination des épaisseurs respectives des couches en premier et second matériaux semiconducteurs constituant une première tranche de la région intermédiaire d'un système comprenant un puits quantique unique assurant un temps de réponse intermédiaire minimum dudit système ;
- une étape de comparaison de ce temps de réponse intermédiaire minimum avec ledit temps de réponse maximum ;
- et la répétition conditionnelle des étapes de détermination et de comparaison en augmentant progressivement le nombre de tranches(ou puits couplés)jusqu'à ce que le temps de réponse obtenu pour un système comprenant un nombre déterminé de puits quantiques couplés soit inférieur audit temps de réponse maximum ou que le temps de réponse pour ce système comprenant ledit nombre déterminé de puits quantiques couplés soit plus grand ou égal au temps de réponse pour un système comprenant un nombre de puits couplés inférieur d'une unité.

L'invention a encore pour objet un photodétecteur à avalanche du type comprenant au moins une région d'absorption de photons dans laquelle sont photoinduits des porteur en un premier matériau semiconducteur à faible largeur de bande interdite, une région de multication des porteurs en un second matériau semiconducteur à grande largeur de bande interdite, et une troisième région intermédiaire constituée par un réseau de tranches de couches alternées des premier et second matériaux formant un système de puits quantiques couplés séparés par des barrières de potentiel, caractérisé en ce que le ladite région intermédiaire comporte un nombre de tranches de couches alternées d'épaisseurs variables assurant un temps de réponse inférieur ou égal audit temps de réponse inférieur ou égal au temps de réponse maximum

L'invention sera mieux comprise et d'autres caractéristiques et avantages apparaîtront à la lecture de la description ci-après et en références aux figures annexées parmi lesquelles :

- la figure 1 illustre le diagramme de bandes au voisinage de l'hétérojonction d'une photodiode à avalanche à absorption et multiplication séparées, selon une première approche de l'Art Connu ;
- la figure 2 illustre le diagramme de bande d'une photodiode à zones d'absorption et de multiplication séparées dans laquelle l'hétérojonction abrupte est remplacée par une structure de composition variable et de bande interdite variable, selon une seconde approche de l'Art Connu ;
- la figure 3 illustre le diagramme de bandes d'une photodiodes à zones d'absorption et de multiplication séparées par des couches alternées des matériaux des zones d'absorption et de multiplication selon une troisième approche de l'Art Connu ;
- la figure 4 illustre le diagramme de bandes d'une photodiode selon l'invention ;
- la figure 5 illustre un détail du diagramme de bande de valence d'une telle photodiode ;
- la figure 6 illustre un diagramme de bande de valence d'une photodiode selon l'invention pour un exemple de réalisation particulier.

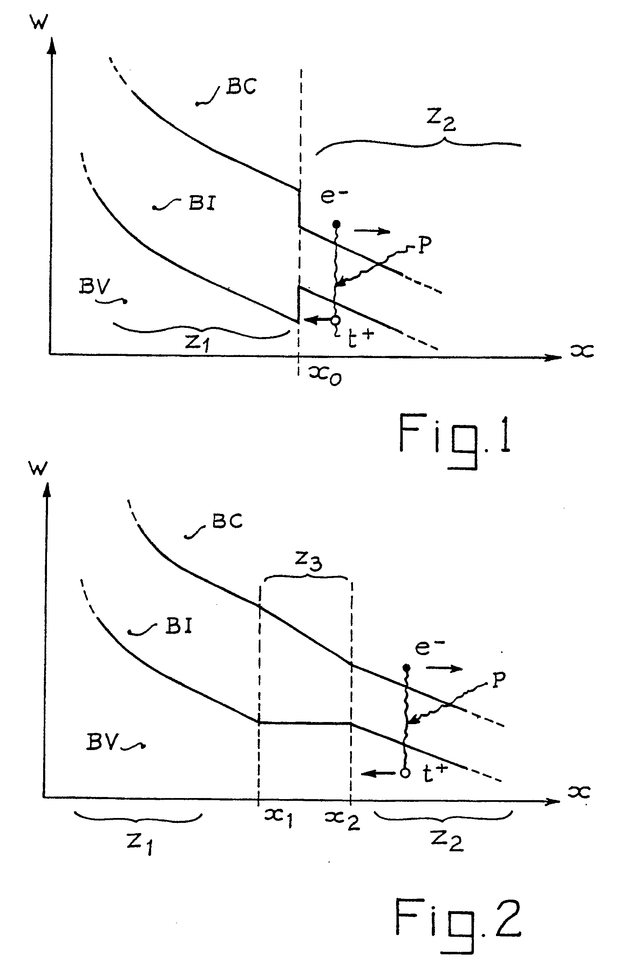

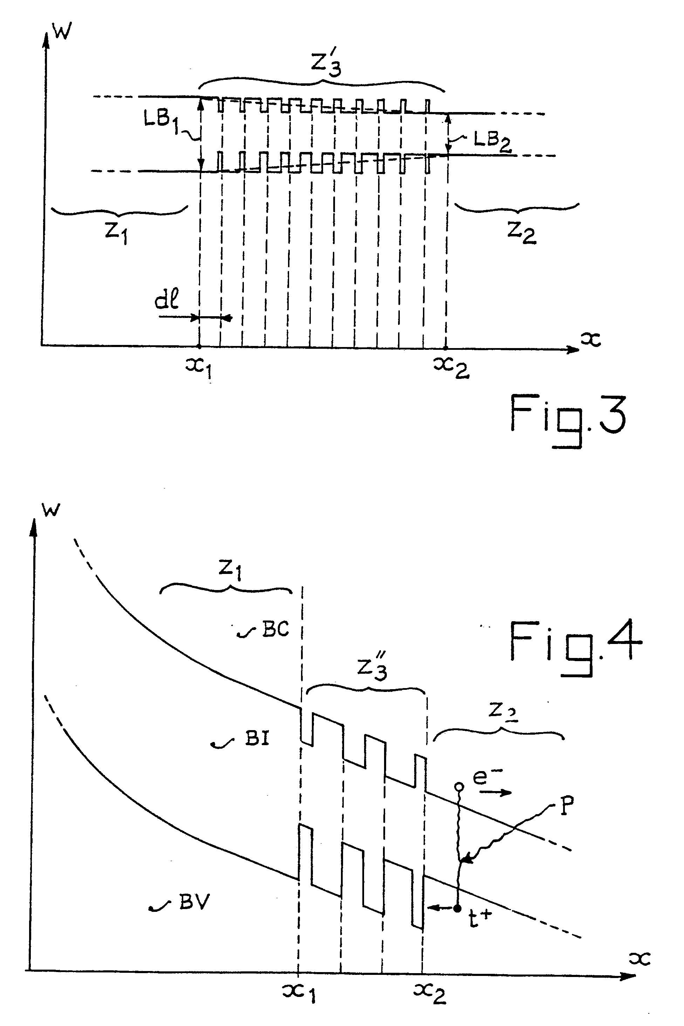

La figure 1 illustre schématiquement le diagramme de bandes au voisinage d'une jonction de l'hétérojonction d'une photodiode à avalanche à zones d'absorption et de multiplication séparées, selon une première approche de l'Art Connu, ainsi que le mécanisme de génération d'une paire électron-trou par captation de photon dans la zone d'absorption.

L'axe vertical du diagramme représente des niveaux d'énergie et l'axe horizontal des distances arbitraires par rapport à une abscisse $x_0$ de l'interface entre les deux zones $Z_1$ et $Z_2$.

La zone $Z_2$ est en matériau à faible largeur de bande interdite. Cette zone $Z_2$ est une zone d'absorption de photons p atteignant la jonction.

La zone $Z_1$ en matériau à plus grande largeur de bande interdite est une zone de multiplication des porteurs par avalanche.

Des photons p d'énergie h $\nu$ créent des paires "électron $e^-$ trou $t^+$". La valeur h est la constante de PLANCK et $\nu$ la fréquence du photon absorbé. Les trous vont être entraînés de la zone $Z_2$ d'absorption vers la zone $Z_1$ de multiplication par avalanche sous l'influence du champ électrique régnant dans la jonction. Cependant, du fait de la barrière de potentiel présente à l'interface, les porteurs créés peuvent être "piégés" à ce niveau et stockés temporairement. Le processus de diffusion est donc ralenti.

Pour pallier cet inconvénient, il a été proposé, selon une seconde approche de l'Art Connu, de disposer un matériau semiconducteur de composition variable entre les deux zones $Z_1$ et $Z_2$, d'absorption et d'avalanche. Le but est d'effectuer une transition à variation continue entre les deux zones extrêmes. Pour ce faire, la composition du matériau est continûment variable entre ces deux zones. Il en est de même en ce qui concerne la largeur de la bande interdite.

La figure 2 illustre une telle disposition.

Le diagramme de bande comprend une troisième zone $Z_3$ d'épaisseur $(x_2-x_1)$, $x_1$ et $x_2$ représentant les abscisses des frontières des zones extrêmes $Z_1$ et $Z_2$.

La zone intermédiaire $Z_3$ assure donc théoriquement une transition parfaitement graduée entre les zones extrêmes. L'effet de piégeage est évité si le produit de la longueur de la zone de transition $x_2 - x_1$ par le gradient de l'énergie potentielle électrostatique F est supérieure à la discontinuité de potentiel V de la bande de valence [ $(x_2 - x_1)$ F>V]. Le procédé suivant l'invention qui sera décrit ultérieurement n'est pas soumis à cette contrainte.

Cependant, le matériau de cette zone intermédiaire $Z_3$ est un alliage, en proportions variables, des matériaux extrêmes. Il s'agit bien sûr de matériaux cristallins. Aussi cette composition variable doit être accordée en maille avec les deux matériaux extrêmes.

Comme il a été rappelé, cette exigence peut être satisfaite pour certains types de matériaux. Par exemple, l'exigence qui vient d'être énoncée peut s'appliquer à des hétérojonctions de structure Gallium-Arsenic/Aluminium-Gallium-Arsenic (GaAs/AlGaAs). Pour d'autres structures d'hétérojonctions, la variation de composition est techniquement très difficile à réaliser, voire pratiquement impossible.

C'est le cas par exemple pour une hétérojonction du type Indium-Gallium-Arsenic/Indium-Phosphore (In Ga As/InP).

Aussi, il a été proposé de réaliser un alliage "pseudo-quaternaire". Pour ce faire, on dispose entre les zones extrêmes non plus une couche de matériau de composition continûment variable, mais un réseau de couches, toutes d'épaisseur constante. Chaque couche est en réalité constituée de deux sous-couches distinctes : une première sous-couche en matériau de l'une des deux zones extrêmes et une seconde sous-couche en matériau de l'autre zone extrême. L'épaisseur de ces sous-couches est variable et égale à l'épaisseur de quelques couches atomiques. Selon cette méthode, les nombres de couches atomiques dans chacune des sous-couches sont déterminés de manière à simuler, d'une couche à l'autre, une variation de largeur de bande moyenne se rapprochant de la variation continue obtenue par une composition variable de la zone intermédiaire $Z_3$, selon la seconde approche de l'Art Connu. Il s'agit en quelque sorte d'une méthode de "discrétisation".

Une telle méthode est décrite dans l'article de CAPASSO et al précité.

La figure 3 illustre l'allure du diagramme de bande de la zone intermédiaire $Z'_3$. Cette zone est constituée d'un empilement de tranches de matériaux, d'épaisseur constante dl, constituées chacune de la succession d'un certain nombre de couches atomiques du matériau de la zone $Z_1$ puis du matériau de la zone $Z_2$. Sur la figure 3, le nombre de couches atomiques du matériau de la zone $Z_1$ d'une tranche diminue progressivement de la gauche (abscisse $x_1$, limite de la zone $Z_1$) vers la droite (abscisse $x_2$, limite de la zone $Z_2$) et le nombre de couches atomiques du matériau de la zone $Z_2$ augment corrélativement. La largeur de bande interdite moyenne varie donc d'une tranche à l'autre de manière à passer progressivement de la valeur $LB_1$, largeur de bande interdite du matériau de la zone $Z_1$, à la valeur $LB_2$, largeur de la bande interdite du matériau de la zone $Z_2$.

Cette méthode ne permet pas cependant d'obtenir une structure optimisée, car il est nécessaire, pour réaliser l'adaptation souhaitée entre les largeurs de bandes interdites, de créer un grand nombre d'interfaces intermédiaires. De plus cette méthode suppose que les porteurs se comportent comme s'ils n'étaient sensibles qu'à la largeur de bande interdite moyenne dans une couche. Le procédé suivant l'invention présenté ci-après est indépendant de la validité d'une telle hypothèse.

Outre les difficultés de fabrication corrélatives à la multiplication du nombre d'interfaces, il y a lieu de remarquer que la qualité du dispositif risque de se dégrader car chaque interface engendre des défauts.

L'invention concerne des photodétecteurs à avalanche comportant également une zone intermédiaire constituée par un réseau de couches alternées de matériaux des zones extrêmes d'absorption et de multiplication des porteurs par avalanche.

Cependant l'invention part d'une approche différente par laquelle il n'est pas cherché à adapter les largeurs de bande. Cette approche permet, tout en conservant les avantages des photodétecteurs du type qui vient d'être rappelé, notamment la rapidité, de réduire de façon significative le nombre d'interfaces nécessaires et donc d'optimiser la structure du photodétecteur à avalanche.

Les phénomènes physiques mis en jeu vont tout d'abord être rappelés.

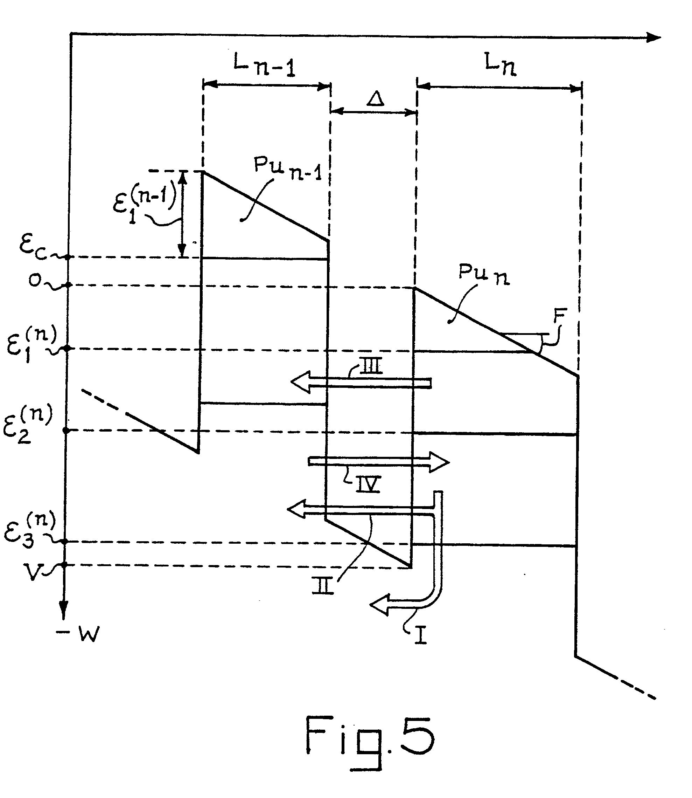

La figure 4 illustre schématiquement une structure de bandes d'un dispositif selon l'invention.

Chaque tranche comprend également, comme dans le cas d'un dispositif de l'Art Connu selon la figure 3, une couche de matériau de la zone $Z_1$ et une couche de matériau de la zone $Z_2$. Cependant l'épaisseur de ces tranches ainsi que les épaisseurs des couches sont variables. Ces épaisseurs sont déterminées par le procédé de l'invention qui va être explicité dans ce qui suit. Il en va de même du nombre total de tranches. L'ensemble forme un système de puits quantiques couplés séparés par des barrières de potentiel.

La figure 5 illustre une portion agrandie du diagramme de bande de valence de la zone intermédiaire $Z''_3$.

Les porteurs libres piégés par les barrières de potentiel des interfaces peuvent franchir celles-ci de plusieurs façons :
- effet thermoémissif ;
- effet tunnel ;
- "hopping" c'est-à-dire saut assisté par phonons ou par interactions avec des impuretés ;
- etc...

La figure 5 illustre ces mécanismes.

On appelle $j_n^t$, pour un puits d'indice arbitraire n, le flux de porteurs vers le continuum, en direction du matériau à grande bande interdite (figure 4 : zone $Z_1$) par particule piègée dans le puits d'indice n. Ce flux provient de l'effet thermoémissif (référence I sur la figure 5) ou de l'effet tunnel (référence II) au travers du haut de la barrière de potentiel entre le puits d'indice n et le puits couplé adjacent d'indice n-1.

On appelle $j_n^-$ le flux (référence III) vers le puits adjacent d'indice n-1 par particule piégée dans le puits d'indice n, dû à l'effet tunnel en général, assisté par phonons ou impuretés.

On appelle

$$j_{n-1}^{\rightarrow}$$

le flux vers le puis d'indice n, par particule piégée dans le puits d'indice n-1 (référence IV).

L'importance relative de ces différents modes d'évasion dépend d'un grand nombre de paramètres, notamment de la température des porteurs, des dimensions de la zone dans laquelle ils sont confinés, de la hauteur et de l'épaisseur des barrières à franchir et du champ électrique appliqué.

On peut évaluer, en fonction de tous ces paramètres, le temps d'évasion dans une structure telle que celle représentée figure 5.

Plus précisément, on peut pour chacun des puits calculer le flux moyen par particule de ce puits vers le continuum, $j_n^\uparrow$, le flux par particule vers le puits voisin de gauche lorsqu'il existe, $j_n^-$, et vers le puits voisin de droite, $j_n^-$. On considère la région d'absorption $Z_2$ comme un (N + 1)ième puits de longueur infinie, le nombre de puits total étant égal à N.

Le nombre de porteurs $\nu_n$ piégés dans le puits d'indice n, vérifie l'équation différentielle :

$$\frac{d\,\nu_n}{dt} = -\sum_{m=1}^{N+1} J_{n,m}\,\nu_m\,(t) \qquad\qquad (1)$$

$$\text{avec } 1 \leqslant n \leqslant N+1$$

équation dans laquelle :

$$J_{n+1,\,n} = -j_n^{\rightarrow}\,;\ J_{n-1,\,n} = -j_n^{\leftarrow} \qquad \text{et} \qquad J_{n,n} = j_n^\uparrow + j_n^{\rightarrow} + j_n^{\leftarrow}$$

les autres coefficients de la matrice associée à cette équation étant nuls.

La matrice J est définie positive et la plus petite de ses valeurs propres $\lambda_1$ donne l'inverse du temps de réponse du système.

De la connaissance des coefficients $j_n$ on peut donc déterminer le temps de réponse d'un système de puits couplés comme illustré sur la figure 4.

La détermination des coefficients $j_n$ va maintenant être explicitée.

Si l'on considère qu'une particule sur deux est émise vers le matériau de grande bande interdite : région $Z_1$ ; on peut montrer que le flux $j_n^\uparrow$ obéit à la relation :

$$j_n^\uparrow \simeq \frac{2kT}{h}\,\exp\,-\left(\frac{V - \varepsilon_1^{(n)}}{kT}\right) \qquad\qquad (2)$$

pour des champs électriques de quelques dizaines de kilovolts par centimètre ; relation dans laquelle :

T est la température en degré Kelvin ;

V est la discontinuité de bande comme illustré sur la figure 5 ;

$$\varepsilon_1^{(n)}$$

est l'énergie du premier niveau lié comptée à partir du bas de la bande de potentiel comme illustré sur figure 5.

k et h sont respectivement les constantes de BOLTZMANN et de PLANCK.

On peut évaluer $\bar{j_n}$ en tenant compte de l'expression des fonctions d'onde dans les puits n et (n-1), calculées comme si ces puits étaient isolés, et du hamiltonien d'interaction avec les phonons.

Une évaluation plus grossière consiste à considérer que la probabilité de transfert est la même que si le puits d'indice (n-1) était illimité pour les états dont l'énergie est supérieure au niveau fondamental du puits (n-1) et qu'elle est nulle dans les autres cas.

$\bar{j_n}$ obéit alors à la relation :

$$j_n = \rho_0 \, kT \sum_i Max\left(1, \frac{FL_n}{\varepsilon_i}\right) \frac{\sqrt{\varepsilon_i}}{\sqrt{2m^*} \, L} \, \theta^\circ \left(\frac{2\varepsilon_i}{V} - 1\right) \, F(\varepsilon_i, \varepsilon_c)$$

dans laquelle :

$$F(\varepsilon_i, \varepsilon_c) = \exp\left[\frac{V\varepsilon_i}{kT} - \beta\sqrt{V - \varepsilon_i} - Min\left(0, \frac{\varepsilon_c - \varepsilon_i}{kT}\right)\right] \quad (3)$$

$$\rho_0 = 4\pi \frac{m^* S}{h^2}$$

est la densité d'état à deux dimensions ;

$m^*$ est la masse effective ;

S est la surface de l'échantillon ;

$L_n$ est la largeur du puits n: $Pu_n$ ;

F est le gradient d'énergie potentielle électrique comme illustré sur la figure 5 ;

La somme $\sum_i$ porte sur tous les niveaux du puits, solutions du hamiltonien à une dimension d'énergie $\varepsilon_i$ inférieure à la discontinuité V des bandes de valence des deux matériaux.;

$$\theta^\circ(x) = 2 \quad \frac{1 - x^2}{1 + 3x^2}$$

est un facteur géométrique de trans parence de la barrière compris entre 0 et 2 ;

$$\beta = 4\pi \frac{\sqrt{2m^*} \, \Delta}{h}$$

où $\Delta$ est l'épaisseur de la barrière d'indice (n-1) ; et $\varepsilon_c = \varepsilon_1(L_{n-1}, F) - F \cdot (L_{n-1} + \Delta)$ où $\varepsilon_1(L_{n-1}, F)$ est le premier niveau du puits d'indice n-1 : $Pu_{n-1}$, dont l'épaisseur est $L_{n-1}$, $\varepsilon_c$ est l'énergie critique en deçà de laquelle ce modèle simplifié suppose que la barrière réfléchit les particules.

Le coefficient $\bar{j_n}$ peut être évalué de manière analogue.

Inversement, si le temps de réponse limite est imposé, on peut donc trouver un système de puits quantiques couplés garantissant un temps de réponse inférieur à ce temps de réponse limite imposé.

C'est le cas en général. En effet, un dispositif photodétecteur à avalanche à hétérojonction selon l'Art Connu, dont un jeu de caractéristiques géométriques, physiques, électriques, etc... est imposé, est caractérisé par un temps de réponse déterminé.

L'invention propose un procédé permettant de réaliser un photodétecteur à avalanche garantissant un temps de réponse inférieur à ce temps de réponse, tout en ne nécessitant qu'un nombre minimum de puits couplés.

On va tout d'abord décrire une variante générale du procédé selon l'invention. Dans ce qui suit, on décrira également une variante simplifiée du procédé.

On suppose connue la discontinuité de bande et le champ électrique local imposé par les conditions de fonctionnement du dispositif.

Soit $t_0^*$ le temps de réponse de l'hétérojonction abrupte.

Soit $t_1(n,\delta)$ le temps de réponse d'un système dans lequel on a intercalé entre les deux matériaux extrêmes un puits de n couches atomiques du matériau à petite bande interdite et une barrière de δ couches atomiques du matériau à grande bande interdite. Pour n donné $t_1$ $(n,\delta)$ est une fonction d'allure convexe qui admet un minimum $t_1^*(n)$ pour une épaisseur de barrière de $\delta^*(n)$ couche. Ce minimum est déterminé en un nombre fini d'opérations. De même la fonction $t_1^*(n)$ admet un minimum $t_1^{**}$ pour $n = n_1^*$.

$t_1^{**}$ qui est le temps de réponse d'un système comportant un puits de $n_1^*$ couches et une barrière de $\delta_1^*$ $(n_1)$ couches atomiques est le meilleur temps qui peut être obtenu avec un seul puits quantique intermédiaire.

On peut de même déterminer $t_2^{**}$, $t_3^{**}$, ..., $t_n^{**}$ etc. De la façon la plus générale, $t_n^{**}$ est donc le temps du meilleur système à n puits intermédiaires. La suite des temps $t_n^{**}$ commence par être décroissante et le reste en général assez longtemps, ce jusqu'à une limite $t^{***}$ où un nouveau puits intermédiaire n'apporte plus de gain de temps.

Si $t_R$ est le temps de réponse fixé pour un dispositif photodétecteur à optimiser, on peut se trouver dans trois situations dont deux situations limites.

Les deux situations limites sont :

a) Si $t_R$ est supérieur à $t_0^{***}$ un dispositif à hétérojonction abrupte convient et le procédé de l'invention ne trouve pas d'application avantageuse dans ce cas.

b) Si $t_R$ est inférieur à $t^{***}$, il n'est pas possible d'atteindre le temps requis avec un système de puits quantique couplés dans les conditions de fonctionnement du dispositif prévu. On peut naturellement envisager de modifier celles-ci pour augmenter le champ électrique local ou pour augmenter la température.

Enfin, dans le cas général pour lequel le procédé selon l'invention trouve toute son application, on détermine le nombre de puits n tel que la relation

$$t_{n-1}^{**} > t_R > t_n^{**}$$

soit vérifiée, soit en utilisant les valeurs $t_1^{**}$ à $t^{***}$ si celles-ci sont connues, soit en les déterminant une à une jusqu'à ce que l'inégalité ci-dessus soit vérifiée. Il s'agit donc dans ce dernier cas d'un processus itératif.

La variante du procédé selon l'invention qui vient d'être décrite est la variante la plus générale et garantit la meilleure structure possible de photodétecteur à avalanche, c'est-à-dire une structure optimisée comportant le minimum de puits couplés. Ceci offre l'avantage d'une fabrication plus aisée et de limiter le risque d'apparition de défauts en minimisant le nombre d'interfaces.

Cette variante du procédé s'avère cependant, généralement, assez longue à mettre en oeuvre.

Pour certaines applications, en acceptant certaines hypothèses simplificatrices, qui vont être explicitées dans ce qui suit, on peut aboutir à une variante du procédé selon l'invention plus rapide à mettre en oeuvre.

On considère pour cette variante des systèmes qui seront appelés "thermalisés" pour lesquels les temps de traversée des barrières dans la direction du courant global $(1/\overline{j_n})$ doivent tous être inférieurs à une fraction du temps de réponse recherché $t_R$. Cette fraction peut être choisie égale typiquement à 20% du temps pour les systèmes comportant une demi-douzaine de puits et à 10% si les puits sont plus nombreux. Il suffit alors que le flux thermoémissif $j_n^\dagger$ du premier puits crée un courant de fuite suffisant, typiquement la condition $(1/j_n^\dagger) < (t_R/2)$ convient, pour que le système de fuite se comporte comme un ensemble de vases communicants, c'est l'intérêt de la condition de "thermalisation", et que les porteurs s'échappent avec un temps caractéristique $t_R$.

On impose aussi aux systèmes d'être "à niveaux d'énergie croissants". C'est-à-dire que le premier niveau du puits d'indice $(n+1)$ doit avoir une énergie supérieure à celui du puits n. En d'autres termes, la diminution d'énergie de localisation due à la plus grande épaisseur du puits d'indice $(n+1)$ doit être inférieure à l'augmentation d'énergie potentielle due au champ électrique. Il est même souvent souhaitable que l'écart entre les premiers niveaux successifs soit d'au moins 1 meV pour éviter les phénomènes de résonance des niveaux.

Cette condition empêche l'apparition dans un puits d'une densité d'état non nulle au-dessous du premier niveau calculé comme si le puits était isolé des puits se trouvant à sa droite. On peut ainsi construire le système de puits "de gauche à droite" sans avoir à faire d'évaluation globale du temps de réponse. Sous ces conditions, le temps de fuite d'une particule piégée dans le puits d'indice n ne dépend que de l'épaisseur du puits n, de la largeur de la barrière d'indice $(n-1)$ et, d'une manière beaucoup moins sensible, si la condition du niveau croissant est réalisée, de la largeur du puits d'indice $(n-1)$.

On détermine une bonne structure "thermalisée" à niveaux d'énergies croissants conduisant à un temps de réponse inférieur au temps requis $t_R$ de la façon qui va maintenant être décrite. Le temps

EP 0 206 918 B1

d'évasion vers le matériau à grande bande interdite d'une particule piégée dans le premier puits croît avec la largeur de celui-ci, on détermine donc, pendant une étape initiale, la plus grande largeur compatible avec le temps requis $t_R$ en se donnant par exemple pour critère $(1/j_n^!) < (t_R/2)$. Si le temps requis est plus grand que le temps de réponse d'une hétérojonction abrupte, il est évidemment inutile de construire des barrières intermédiaires.

On procède ensuite de façon itérative.

On suppose connue la structure jusqu'au n-ième puits. On détermine alors les épaisseurs des (n + 1)-ièmes barrières et puits. En première approximation, le temps de séjour d'un porteur dans le (n + 1)ème puits croît avec l'épaisseur de celui-ci et a souvent tendance à décroître avec celle de la barrière. On recherche la combinaison d'épaisseurs compatible avec le temps requis permettant d'avoir le puits le plus épais.

Trois cas peuvent se présenter :

a) il est possible d'avoir un (n + 1)ième puits de longueur infinie. Le processus est alors terminé : on a réalisé la transition avec le matériau à petite bande interdite.

b) Le plus grand puits compatible avec le temps requis est plus épais que le puits précédent. On continue le processus itératif.

c) On n'arrive pas à obtenir le temps requis avec un puits plus épais que le précédent : le temps requis est trop court. On peut soit modifier l'ensemble du dispositif pour augmenter l'intensité du champ électrique, ce qui diminue les temps de réponse, soit éventuellement passer outre si les particules piégées dans ce puits particulier sont peu nombreuses relativement au reste du dispositif.

Dans certaines situations, le choix reste ouvert entre plusieurs combinaisons possibles d'épaisseurs pour un même nombre de puits couplés. On peut alors, soit procéder à un choix arbitraire, soit mettre en oeuvre la méthode de calcul générale exposée dans la variante générale du procédé de l'invention qui permet de déterminer la structure la plus optimisée parmi les structures possibles compte-tenu du temps de réponse imposé.

Pour fixer les idées, on a réalisé par le procédé de l'invention, dans sa seconde variante, une photodiode à avalanche pouvant fonctionner à 2 GHz. Cela correspond à un temps de réponse $t_R$ inférieur ou égal à 250 ps.

Les matériaux des régions extrêmes $Z_1$ et $Z_2$ étaient respectivement de l'Indium-Phosphore (InP) et de l'Indium-Gallium-Arsenic (InGaAs).

Les autres paramètres fixés étaient les suivants :
- discontinuité de bande de valence: 350 meV ;
- champ électrique local : 100 kVcm$^{-1}$.

Dans ces conditions, une photodiode à avalanche à hétérojonction abrupte est caractérisé par un temps de réponse de l'ordre de 200 ns, d'où une fréquence maximale d'utilisation 30 MHz.

La zone intermédiaire $Z''_3$ déterminée conformément au procédé de l'invention doit comporter cinq puits quantiques couplés, la zone extrême $Z_2$ étant considérée comme un sixième puits d'épaisseur infinie.

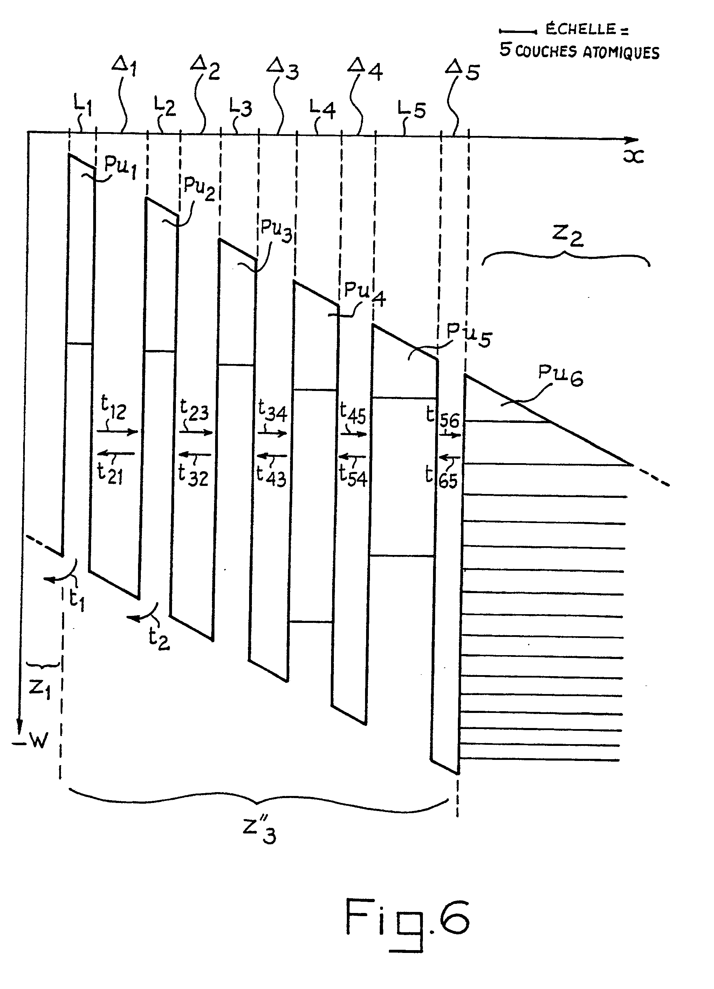

La figure 6 illustre schématiquement le diagramme de bande de valence de la photodiode à avalanche ainsi réalisée.

Les longueurs $L_1$ à $L_5$ représentent les épaisseurs des différents puits en nombre de couches atomiques comme indiqué sur l'échelle associée à l'axe horizontal.

Les longueurs $\Delta_1$ à $\Delta_5$ représentent les épaisseurs des différentes barrières du potentiel également en nombre de couches atomiques.

Une couche atomique a une épaisseur de 2,9347 Å.

Les couples de temps $t_{12}$, $t_{21}$ à $t_{56}$, $t_{65}$ représentent les temps de transfert de puits à puits (puits $Pu_1$ à $Pu_6$). Ces temps correspondent respectivement aux inverses des paramètres $j_n^-$ et $j_n^-$ précédemment décrits.

Les valeurs numériques de ces paramètres sont portées dans le tableau I disposé en fin de la présente description.

On peut constater à la lecture de ce tableau que l'épaisseur totale des tranches de matériaux composites (épaisseur des puits plus épaisseur des barrières de potentiel) n'est pas constante.

Il a été également indiqué les temps $t_1$ et $t_2$ qui correspondent aux temps de diffusion vers le continuum pour les puits $Pu_1$ et $Pu_2$.

Pour les puits d'indices supérieurs, les flux de particules vers le continuum ne sont plus significatifs car ils correspondent à des temps très supérieurs au temps de réponse fixé $t_R$ = 250 ps. Comme il ressort du tableau I, le temps $t_2$ est égal à 525 ps. Le flux de particules du puits $Pu_2$ vers le continuum peut donc déjà être négligé. Les temps $t_1$ et $t_2$ et plus généralement les temps $t_n$, bien que non indiqués dans le tableau I, correspondent à l'inverse des paramètres $j_n^!$ précédemment décrits.

Les positions des niveaux d'énergies correspondant aux différents puits ont été représentés par des traits horizontaux. Les puits Pu$_1$ à Pu$_3$ comportent un seul niveau d'énergie. Les puits Pu$_4$ et Pu$_5$ en comportent deux. La zone Z$_2$, considérée comme un puits d'épaisseur infinie en comporte naturellement un grand nombre : seize dans l'exemple illustré.

A une fréquence de travail de 2 GHz, si le temps de réponse est effectivement obtenu, un signal fourni par la diode est réduit à $\tau = e^{-500/250}$, soit 14% de sa valeur initiale après une période.

La diagonalisation de la matrice J donne dans l'exemple illustré par la figure 6, une première valeur propre $\lambda_1 = 1,7$ GHz.

Comme le nombre de puits quantiques couplés est six :

$$\tau \simeq \frac{e^{-1,7 \times 0,5}}{\sqrt{6}} \text{ , soit 17\% environ.}$$

On peut donc utiliser le dispositif obtenu par le procédé de l'invention à la fréquence de 2 GHz.

L'invention n'est naturellement pas limitée aux seules variantes d'exécution qui viennent d'être explicitement décrites.

Les variantes du procédé de réalisation dérivées des deux variantes décrites font également partie de l'invention, et notamment une variante du procédé qui consiste à faire une optimisation grossière par la deuxième variante du procédé, puis à affiner celle-ci en comparant, par la méthode de détermination générale consistant à diagonaliser la matrice J définie précédemment, avec des solutions correspondant à une croissance moins rapide des épaisseurs des puits successifs ou à d'autres valeurs des épaisseurs des barrières.

On peut également remplacer la diagonalisation de la matrice J$_n$ par des moyens plus rapides qui consistent par exemple à constater qu'un accroissement d'un des rapport

$$(j_n^{\leftarrow} / j_{n-1}^{\rightarrow}),$$

les autres paramètres restant constants, et l'inverse de J$_n$ respectant toujours la condition d'être inférieur à une fraction déterminée du temps requis, améliore en général le temps de réponse global.

Enfin, bien qu'il ait été considéré dans la description de l'invention, de façon implicite, que les porteurs qui se multiplient prioritairement étaient des trous, il est clair que le procédé s'applique de manière analogue aux applications pour lesquelles les porteurs sont des électrons.

## TABLEAU 1

| Epaisseur en nombre de couches atomiques | Temps de transferts puits à puits (en ps) | Temps de diffusion vers le continuum (en ps) |
|---|---|---|
| $L_1 = 4$) <br> $\Delta_1 = 8$) $L_1+\Delta_1=12$ | $t_{12} = 15$ <br> $t_{21} = 17$ | $t_1 = 150$ |
| $L_2 = 5$) <br> $\Delta_2 = 6$) $L_2+\Delta_2=11$ | $t_{23} = 6$ <br> $t_{32} = 6$ | $t_2 = 525$ |
| $L_3 = 6$) <br> $\Delta_3 = 6$) $L_3+\Delta_2=12$ | $t_{34} = 21$ <br> $t_{43} = 12$ | - |
| $L_4 = 7$) <br> $\Delta_4 = 5$) $L_4+\Delta_3=12$ | $t_{45} = 13$ <br> $t_{54} = 15$ | - |
| $L_5 = 10$) <br> $\Delta_5 = 4$) $L_5+\Delta_5=14$ | $t_{56} = 91$ <br> $t_{65} = 8$ | - |

## Revendications

1.  Procédé de réalisation d'un photodétecteur à avalanche du type comprenant au moins une région ($Z_2$) d'absorption de photons (p), dans laquelle sont photoinduits des porteurs, en un premier matériau semiconducteur à faible largeur de bande interdite, une région ($Z_1$) de multiplication de porteurs, en un second matériau semiconducteur à grande largeur de bande interdite, et une troisième région intermédiaire ($Z''_3$), constituée par un réseau de tranches de couches alternées des premier et second matériaux formant un système de puits quantiques couplés (Pu$_n$)séparés par des barrières de potentiel ; caractérisé en ce que, le photodétecteur étant spécifié pour des conditions de fonctionnement comprenant une discontinuité de bande et un champ électrique local déterminés ainsi qu'un temps de réponse maximum (t$_R$), il comprend une phase de détermination de ladite région intermédiaire (Z"$_3$) comportant un nombre minimum de tranches de couches alternées d'épaisseurs variables assurant un temps de réponse inférieur ou égal audit temps de réponse maximum (t$_R$) et en ce que cette phase comprend :

- une étape de détermination des épaisseurs respectives (L$_1$ $\Delta_1$). des couches en. premier et second matériaux semiconducteurs constituant une première tranche de la région intermédiaire (Z"$_3$) d'un système comprenant un puits quantique unique assurant un temps de réponse intermédiaire minimum (t$_1$$^{***}$) dudit système ;
- une étape de comparaison de ce temps de réponse intermédiaire minimum (t$_1$$^{***}$) avec ledit temps de réponse maximum (t$_R$) ;
- et la répétition conditionnelle des étapes de détermination et de comparaison en augmentant progressivement le nombre de tranches (ou puits couplés) jusqu'à ce que le temps de réponse (t$_n$$^{***}$) obtenu pour un système comprenant un nombre déterminé de puits quantiques couplés (Pu$_n$) soit inférieur audit temps de réponse maximum (t$_R$) ou que le temps de réponse (t$_n$$^{***}$) pour ce système comprenant ledit nombre déterminé de puits quantiques couplés (Pu$_n$) soit plus grand ou égal au temps de réponse pour un système comprenant un nombre de puits couplés inférieur d'une unité.

2. Procédé de réalisation d'un photodétecteur à avalanche du type comprenant au moins une région (Z$_2$) d'absorption de photons (p), dans laquelle sont photoinduites des porteurs en un premier matériau semiconducteur à faible largeur de bande interdite, une région (Z$_1$) de multiplication de porteurs en un second matériau semiconducteur à grande largeur de bande interdite, et une troisième région intermédiaire (Z"$_3$) constituée par un réseau de tranches de couches déterminées des premier et second matériaux formant un système de puits quantiques couplés (Pu$_n$) séparés par des barrières de potentiel ;

caractérisé en ce que, le photodétecteur étant spécifié pour des conditions de fonctionnement comprenant une discontinuité de bande et un champ électrique local déterminé ainsi qu'un temps de réponse maximum (t$_R$), il comprend une phase de détermination de ladite région intermédialre (Z"$_3$) comportant un nombre minimum de tranches de couches alternées d'épaisseurs variables assurant un temps de réponse inférieur ou égal audit temps de réponse maximum (t$_R$) et en ce que cette phase comprend :

- une étape de détermination de l'épaisseur (L1) de la première couche en premier matériau formant un premier puits pour que le temps d'évacuation d'un porteur piégé dans ce puits vers le matériau (Z1) à grande largeur de bande interdite soit inférieur de moitié audit temps de réponse maximum (t$_R$) ;
- une étape de détermination des épaisseurs des tranches qui suivent, respectivement en second matériau formant barrière et en premier matériau formant puits, de manière à ce que le temps d'évasion vers le puits précédent soit inférieur ou égal à une fraction déterminée du temps de réponse maximum, et que le nouveau puits soit le plus épais possible ;
- et la répétition conditionnelle de cette étape en augmentant progressivement le nombre de puits quantiques couplés de manière à réaliser une structure à puits quantiques couplés d'épaisseurs croissantes, ladite répétition ayant lieu jusqu'à ce que la largeur possible du dernier puits tende vers l'infini ou qu'elle ne puisse être strictement supérieure à celle du puits qui le précède.

3. Procédé selon la revendication 2, caractérisé en ce que ladite fraction du temps de réponse (t$_R$) est égale à 20%.

4. Procédé selon l'une quelconque des revendications 1 à 3, caractérisé en ce que ledit premier matériau semiconducteur est de l'Indium-Phosphore (InP) et en ce que ledit second matériau semiconducteur est de l'Indium-Gallium-Arsenic (InGaAs).

5. Procédé selon l'une quelconque des revendications 1 à 4, caractérisé en ce que lesdits porteurs sont des trous.

6. Procédé selon l'une quelconque des revendications 1 à 4, caractérisé en ce que lesdits porteurs sont

EP 0 206 918 B1

des électrons.

7. Photodétecteur à avalanche du type comprenant au moins une région (Z₂) d'absorption de photons (p), dans laquelle sont photoinduits des porteurs en un premier matériau semiconducteur à faible largeur de bande interdite, une région (Z₁) de multiplication des porteurs en un second matériau semiconducteur à grande largeur de bande interdite, et une troisième région intermédiaire (Z"₃) constituée par un réseau de tranches de couches alternées des premier et second matériaux formant un système de puits quantiques couplés (Puₙ) séparés par des barrières de potentiel réalisé selon le procédé de l'une des revendications 1 à 6, caractérisé en ce que ladite région intermédiaire (Z"₃) comporte un nombre minimum de tranches de couces alternées d'épaisseurs variables assurant un temps de réponse inférieur ou égal audit temps de réponse maximum (t_R).

## Claims

1. A process for the manufacture of an avalanche photodetector of the type comprising at least one region (Z₂) for the absorption of photons (p), in which carriers are photoinduced, made of a first semiconductor material with a small width of the forbidden band, a region (Z₁) for the multiplication of carriers, made of a second semiconductor material with a large width of the forbidden band, and a third intermediate region (Z"₃), constituted by a lattice of alternating slices of layers of the first and of the second material forming a system of coupled quantum wells (Puₙ) separated by potential barriers; characterized in that the photodetector is specified for conditions of operation comprising a given band discontinuity and a given local electric field and a maximum response time (t_R), and said process comprises a phase for the determination of the said intermediate region (Z"₃) comprising a minimum number of slices of alternating varying thicknesses ensuring a response time less than or equal to the said time of maximum response (t_R) and in that the phase comprises:
   - a step of the determination of the respective thicknesses (L₁ and Δ₁) of the layers made of the first and of the second semiconductor material constituting a first slice of the intermediate region (Z"₃) of a system comprising a single quantum well ensuring a minimum intermediate response time (t₁***) of the said system;
   - a step of comparison between this minimum intermediate response time (t₁**) and the said maximum response time (t_R);
   - and the ccnditional repetition of the determination and comparison steps while progressively increasing the number of slices (or coupled wells) until the response time (tₙ**) obtained for a system comprising the said determined number of coupled quantum wells (Puₙ) is less than the maximum response time (t_R) or the response time (tₙ**) for this system comprising the said determined number of coupled quantum wells (Puₙ) is greater than or equal to the response time for a system comprising a number of coupled wells less than one unit.

2. The process of manufacture an avalanche photodetector of the type comprising at least one region (Z₂) for the absorption of photons (p), in which carriers are photoinduced, made of a first semiconductor material with a small width of the forbidden band, a region (Z₁) for the multiplication of carriers made of a second semiconductor material with a large width of the forbidden band, and a third intermediate region (Z"₃) constituted by a lattice of given layers of the first and of the second material forming a system of coupled quantum wells (Puₙ) separated by potential barriers; characterized in that the photodetector is specified for conditions of operation comprising a discontinuity in the band and a determined local electric field and also a maximum response time (t_R) and the process comprises a phase for the determination of the said intermediate region (Z"₃) comprising a minimum number of slices of alternating layers with varying thicknesses ensuring a response time less than or equal to the said maximum response time (t_R) and in that the said phase comprises:
   - a step of determination of the thickness (L1) of the first layer made of the first material forming a first well so that the time of removal of a carrier trapped in the well into the material (Z1) with a large width of the forbidden band is less half than the time of maximum response (tR);
   - a step of determination of the thicknesses of the slices which then follow, made respectively of the second material forming the barrier and of the first material forming a well in such a manner that the time of escape towards the preceding well is less than or equal to a determined fraction of the maximum response time, and in that the new well is as thick as possible;
   - and the conditional repetition of this step while progressively increasing the number of coupled

12

quantum wells in such a manner as to form a structure with coupled quantum wells with increasing thicknesses, the said repetition taking place until the possible width of the last well tends towards infinity or until it cannot be greater than that of the well which precedes it.

3. The process as claimed in claim 2, characterized in that the said fraction of the response time ($t_R$) is equal to 20%.

4. The process as claimed in any one of the preceding claims 1 through 3, characterized in that the semiconductor material is indium phosphide (InP) and in that the said second semiconductor material is indium gallium arsenide (InGaAs).

5. The process as claimed in any one of the preceding claims 1 through 4, characterized in that the said carriers are holes.

6. The process as claimed in any one of the preceding claims 1 through 4, characterized in that the said carriers are electrons.

7. An avalanche photodetector of the type comprising at least one region ($Z_2$) for the absorption of photons (p), in which carriers are photoinduced, made of a first semiconductor material with small width of the forbidden band, a region ($Z_1$) for the multiplication of carriers and made of a second semiconductor material with a large width of the forbidden band, and a third intermediate region ($Z''_3$) constituted by a lattice of slices of alternating first and second materials forming a system of coupled quantum wells ($Pu_n$) separated by potential barriers, manufactured by the process as claimed in any one of the preceding claims 1 through 6, characterized in that the said intermediate region ($Z''_3$) comprises a minimum number of slices of alternating layers with different thicknesses ensuring a response time less than or equal to the said maximum response time ($t_R$).

## Ansprüche

1. Verfahren zur Herstellung eines Avalanche-Photodetektors vom Typ mit wenigstens einem Gebiet ($Z_2$) zur Absorption der Photonen (p), in welchem Ladungsträger photoinduziert werden, aus einem ersten Halbleitermaterial mit geringer Breite des verbotenen Bandes, mit einem Gebiet ($Z_1$) zum Vervielfachen der Ladungsträger aus einem zweiten Halbleitermaterial mit großer Breite des verbotenen Bandes, sowie mit einem dritten Gebiet, einem Zwischengebiet ($Z''_3$), das aus einer Gruppe von alternierenden Schichtenabschnitten des ersten Materials und des zweiten Materials besteht, die ein System gekoppelter Quantensenken ($Pu_n$) bilden, die durch Potentialbarrieren getrennt sind; dadurch gekennzeichnet, daß der Photodetektor für Betriebsbedingungen spezifiziert ist, die eine bestimmte Banddiskontinuität, ein bestimmtes lokales elektrisches Feld sowie eine maximale Ansprechzeit ($t_R$) umfassen, und das Verfahren eine Phase für die Bestimmung des genannten Zwischengebiets ($Z''_3$) umfaßt, das eine Mindestanzahl von alternierenden Schichtabschnitten von variabler Dicke aufweist, die eine Ansprechzeit gewährleistet, die gleich der maximalen Ansprechzeit ($t_R$) oder kleiner als diese ist, und daß diese Phase umfaßt:
    - einen Schritt zur Bestimmung der jeweiligen Dicken ($L_1$, $\Delta_1$) der Schichten aus einem ersten Halbleiter-Material sowie einem zweiten Halbleiter-Material, welche einen ersten Abschnitt des Zwischengebiets ($Z''_3$) eines Systems bilden, das eine einzige Quantensenke umfaßt, das eine minimale Zwischen-Ansprechzeit ($t_1^{**}$) des genannten Systems gewährleistet;
    - einen Schritt zum Vergleichen dieser minimalen Zwischen-Ansprechzeit ($t_1^{**}$) mit der genannten maximalen Ansprechzeit
    - und die bedingte Wiederholung des Bestimmungsschrittes sowie des Vergleichschrittes, indem die Anzahl der Abschnitte (oder der gekoppelten Senken) zunehmend erhöht wird, bis die Ansprechzeit ($t_n^{**}$), die für ein System erhalten wird, das eine bestimmte Anzahl von gekoppelten Quantensenken ($Pu_n$) umfaßt, kleiner als die genannte maximale Ansprechzeit ($t_R$) ist, oder daß die Ansprechzeit ($t_n^{**}$) für dieses System, welches die genannte bestimmte Anzahl von gekoppelten Quantensenken ($Pu_n$) umfaßt, größer als die oder gleich der Ansprechzeit für ein System ist, das eine um eine Einheit kleinere Anzahl von gekoppelten Quantensenken umfaßt.

2. Verfahren zur Herstellung eines Avalanche-Photodetektors vom Typ mit wenigstens einem Gebiet ($Z_2$)

für die Absorption von Photonen (p), in welchem Ladungsträger aus einem ersten Halbleitermaterial mit geringer Breite des verbotenen Bandes photoinduziert werden, mit einem Gebiet ($Z_1$) zum Vervielfachen der Ladungsträger aus einem zweiten Halbleitermaterial mit großer Breite des verbotenen Bandes sowie mit einem dritten Gebiet, einem Zwischengebiet ($Z''_3$), das aus einer Gruppe von bestimmten Schichtabschnitten des ersten Materials und des zweiten Materials besteht, das ein System von gekoppelten Quantensenken ($Pu_n$) bildet, die durch Potentialbarrieren getrennt sind;

dadurch gekennzeichnet, daß der Photodetektor für Betriebsbedingungen spezifiziert ist, welche eine Banddiskontinuität sowie ein bestimmtes elektrisches lokales Feld sowie eine maximale Ansprechzeit ($t_R$) umfassen, und das Verfahren eine Phase zur Bestimmung des genannten Zwischengebiets ($Z''_3$) aufweist, das eine Mindestanzahl von alternierenden Schichtabschnitten von variabler Dicke umfaßt, die eine Ansprechzeit gewährleisten, die kleiner als die oder gleich der genannten maximalen Ansprechzeit ($t_R$) ist, und daß die Phase umfaßt:

- einen Schritt zur Bestimmung der Dicke (L1) der ersten Schicht aus einem ersten Material, das eine erste Senke bildet, damit die Ableitungszeit für einen in dieser Senke gefangenen Ladungsträger zu dem Material ($Z1$) mit großer Breite des verbotenen Bandes halb so klein wie die maximale Ansprechzeit ($t_R$) wird;
- einen Schritt zur Bestimmung der Dicken der darauffolgenden Schichten, die aus einem eine Barriere bildenden ersten Material bzw. aus einem eine Senke bildenden zweiten Material bestehen, so daß die Ableitungszeit zur vorausgehenden Senke kleiner als ein oder gleich einem bestimmten Bruchteil der maximalen Ansprechzeit wird, und daß die neue Senke so dick wie möglich ist;
- und die bedingte Wiederholung dieses Schrittes, indem die Anzahl der gekoppelten Quantensenken progressiv erhöht wird, so daß eine Struktur mit gekoppelten Quantensenken zunehmender Dicke gebildet wird, wobei die genannte Wiederholung so lange erfolgt, bis die mögliche Breite der letzten Senke gegen Unendlich strebt, oder daß sie nicht größer als die Dicke der ihr vorausgehenden Senke sein kann.

3. Verfahren nach Anspruch 2, dadurch gekennzeichnet, daß der genannte Bruchteil der Ansprechzeit ($t_R$) 20% entspricht.

4. Verfahren nach einem der Ansprüche 1 bis 3, dadurch gekennzeichnet, daß das erste Halbleitermaterial aus IndiumPhosphor (InP) besteht, und daß das zweite Halbleitermaterial aus Indium-Gallium-Arsen (InGaAs) besteht.

5. Verfahren nach einem der Ansprüche 1 bis 4, dadurch gekennzeichnet, daß die Ladungsträger Löcher sind.

6. Verfahren nach einem der Ansprüche 1 bis 4, dadurch gekennzeichnet, daß die Ladungsträger Elektronen sind.

7. Avalanche-Photodetektor vom Typ mit wenigstens einem Gebiet ($Z_2$) zur Absorption von Photonen (p), in welchem Ladungsträger aus einem ersten Halbleitermaterial mit geringer Breite des verbotenen Bandes photoinduziert werden, mit einem Gebiet ($Z_1$) zum Vervielfachen der Ladungsträger aus einem zweiten Halbleitermaterial mit großer Breite des verbotenen Bandes sowie mit einem dritten Gebiet, einem Zwischengebiet ($Z''_3$), das aus einer Gruppe von alternierenden Schichtabschnitten des ersten sowie des zweiten Materials besteht, das ein System gekoppelter Quantensenken ($Pu_n$) bildet, welche durch Barrieren des Potentials getrennt sind, das nach einem der Ansprüche 1 bis 6 ausgeführt wird, dadurch gekennzeichnet, daß das genannte Zwischengebiet ($Z''_3$) eine Mindestanzahl von alternierenden Schichtabschnitten von variabler Dicke umfaßt, die eine Ansprechzeit gewährleisten, die kleiner als die oder gleich der genannten maximalen Ansprechzeit ($t_R$) ist.

Fig.1

Fig.2

Fig.3

Fig.4

Fig.5

Fig.6